# EUROPEAN PATENT SPECIFICATION

(11) **EP 1 732 224 B1**
(45) Date of publication and mention of the grant of the patent: **07.11.2012**
(21) Application number: 05104708.2
(22) Date of filing: 01.06.2005
(51) Int. Cl.: H03K 17/96

(54) **Touch-sensitive control panel**
Berührungsempfindliches Bedienfeld
Panneau de commande tactile

(43) Date of publication of application: 13.12.2006
(73) Proprietor: Electrolux Home Products Corporation N.V., 1130 Brussel (BE)
(72) Inventor: Uhov, Andrei, Saint-Petersburg (RU); Nikitin, Nikolay, Saint-Petersburg (RU); Sazonov, Dmitry, Saint-Petersburg (RU); Giordano, Roberto, 33050, Pozzuolo del Friuli (Udine) (IT)
(74) Representative: Markovina, Paolo

(56) References cited:
- DE-U1-202005 002 157
- JP-A- 57 130 314
- US-A- 4 056 699
- US-A- 5 717 189
- US-A- 5 892 652
- US-B1- 6 329 646

## Description

The present invention refers to an improved type of control panel, of the type of simple touch control, working on the principle of the capacitance variation in an electronic computing and signalling circuit .-

In the following of this description it will be referred to a control panel for general purpose, but it will be understood that what explained will have the best implementation in a control panel used in household appliances.-

It is well known the existence of control panels, of the capacitive type, able to process and send some commands to the actuating devices; such control panels are made, in the simplest and most common case, of an outer plate, generally made of plastics or glass, on which the commands, to be activated by the user, are represented or drawn.-

Inside said outer plate a printed circuit board is lodged, wherein the electronic circuits for the logical and the processing operations are arranged.-

Said printed circuit board is supplied with electronic circuits detecting the presence or absence of an additional capacitance, which is normally generated by the point of a user finger touching a pre-defined position on said plate.-

In order that said electronic circuits would be able to detect such capacitance variation, it is well known to place conductive means between the inner surface of said outer plate and dedicated contact areas properly distributed on said board, and that are an integral part of the electronic circuit.-

Such conductive means can be also elastic means, so that they realize not only transmission means of the capacitance variation, but also supporting and elastic separation means of the outer plate with respect to the inner printed circuit board.-

From EP 0 859 467 B1 (EGO) said conductive and elastic separation means between the outer plate and the electronic board are obtained through a special component made by a sheet of an elastomeric, thick material which is properly treated and added with conductive material known in the art, specially graphite, so that it works as a conductive and elastic component, particularly able of being used as described in the cited patent.-

Such a solution has proven to be both effective and viable on a mass production; however in the long lasting use some drawbacks have been experienced:
- first of all, the kind of material that is used, being basically porous, tends to absorb and to accumulate the moisture that is always present in an household environment;
- as a further question said material tends to degraded in the time, substantially it gets old as any kind of elastomeric material, and so it looses its resilient properties; moreover it tends to pulverize, what generate a criticality for the associated electronic circuits.-

In order to overcome such drawbacks it was proposed a kind of conductive and elastic means simply made of a thin metallic spiral spring, properly placed and blocked; such a solution overcomes the above cited drawbacks, and yet shows the problem that, being very flexible, tends to flex in its intermediate zone, so slipping away from its working position; therefore its positioning becomes delicate and difficult, and therefore burdensome.

It therefore would be desirable, and it is actually a main purpose of the present invention to a provide control panel of the type "touch control" and therefore of the capacitive type, and provided with both an outer plate and an inner electronic board, wherein the capacitive signal is being sent from said outer plate to said inner board through a device able to avoid the above described drawbacks and that implies production burdens which are remarkably reduced.

A capacitive touch control panel according to the preamble portion of claim 1 is known from document US-A-5 892 652.

According to the present invention, the above aims are reached in a particular type of control panel provided with the devices and arrangements as recited in the appended claims and described below by mere way of non-limiting example with reference to the accompanying drawings, in which:
- Figure 1 is an "exploded" perspective view of a control panel;
- Figures 2 to 6 show corresponding perspective views of respective non-claimed examples of devices,
- Figures 2A to 6A show respective views of the devices , shown in the figure 2 to 6, before their sectioning and shaping,
- Figures 7, 8 and 9 shown three perspective views of corresponding improved non-claimed examples with respect to those presented in the figures 2, 3 and 4,
- Figures 10 and 10A show an embodiment of a device according to the invention,
- Figures 11 and 11A show different embodiments of the devices presented in the figure 10 and 10A,
- Figures 12, 13, 14 and 15, show further non-claimed improved variations of the examples represented in figures 2, 7, 8, 9, respectively,

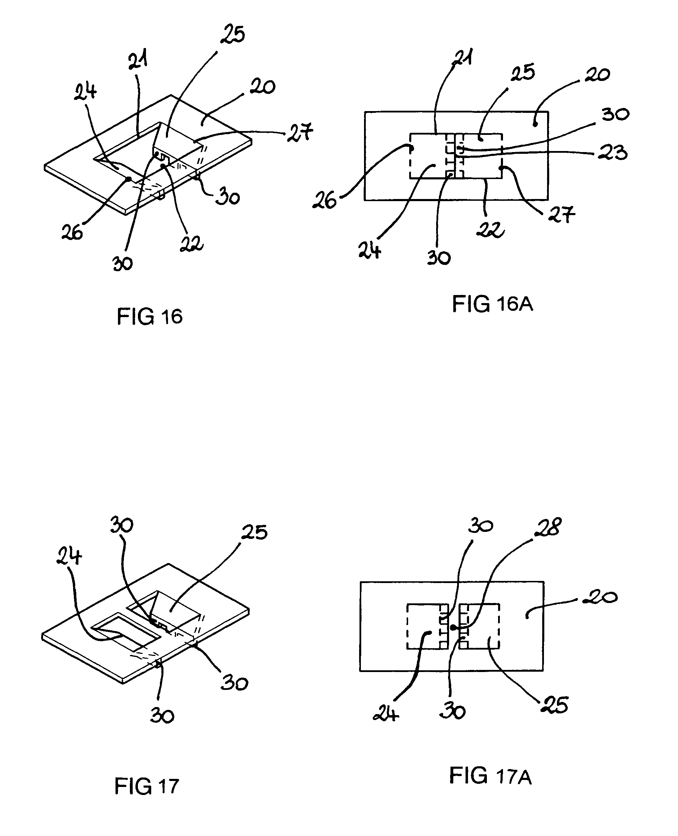

- Figures 16 and 17 show further improved embodiments according to the invention.

The invention is essentially based on using a thin metallic foil, f. i made of stainless steel, which is flexible and conductive, and which is properly shaped.

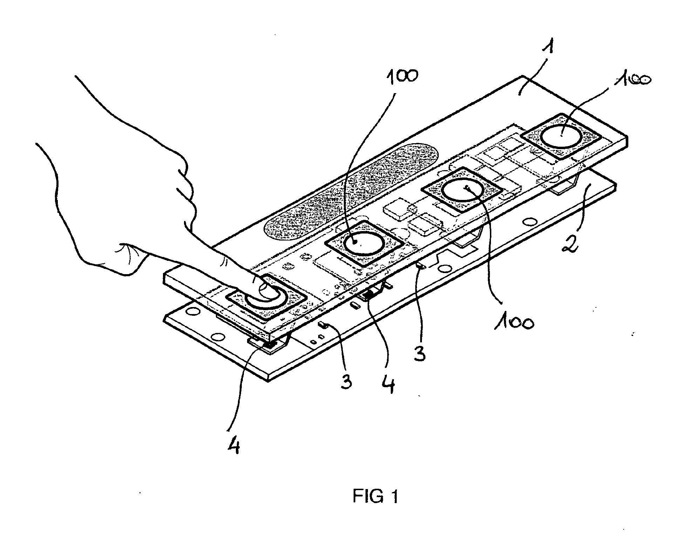

With ref. to fig. 1, a control panel is shown in a transparent view; it can be observed that said control panel comprises an outer plate 1 with external contact areas 100 that can be touched by the user, a control assembly 2 made basically of a printed circuit board provided with electronic circuits 3 and able of performing the requested functions of detecting the contact of these areas 100 by the user, and of switching the related output signal; particularly said board comprises some contact elements 4 laid on it and oriented towards said outer plate, their function being simply of receiving the electrical signals coming from said areas and of transmitting them to the electronic circuit of the board.-

The capacitive signal generated by the contact on said areas 100 is therefore transferred to said contact elements 4 by making it to pass throughout a flexible metallic foil 5, properly shaped and interposed between the inner surface of said outer plate 1 and said contact elements 4 on said printed circuit board.-

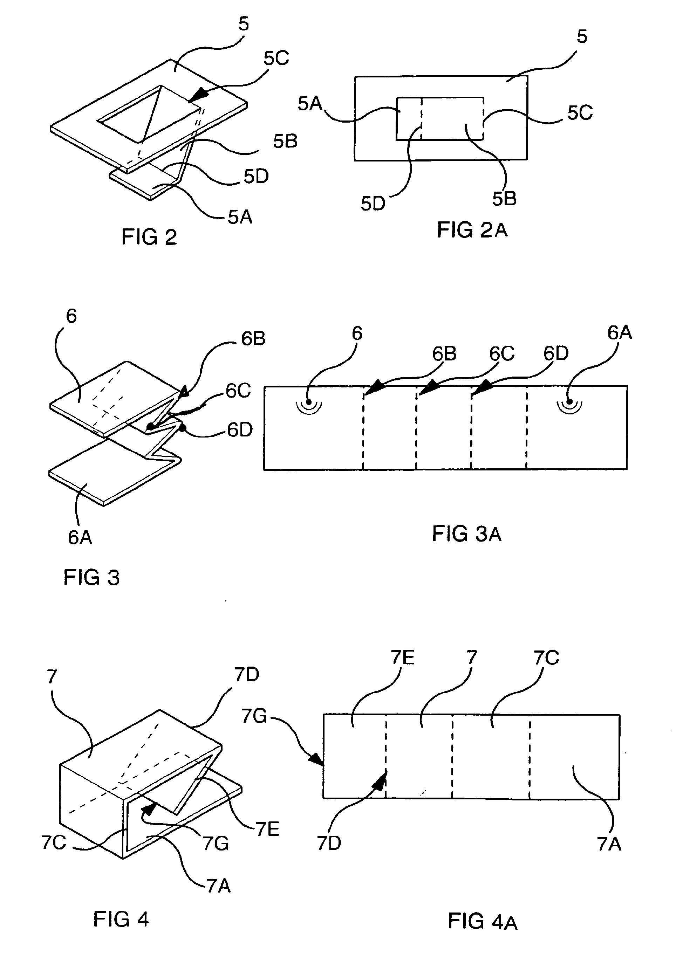

With ref. to figs. 3 and 3A, said foil is obtained simply bending for a plurality of times according respective segments 6B, 6C, 6D etc. the central body of a metallic and rectangular flat foil, so that it is being shaped into a plurality of strips as in an accordion, while the two terminal flat strips 6 and 6A are laid on respective parallel planes among which said strips as accordion are positioned.

Fig. 3A shows the symbolic representation on a plane of the foil (for sake of simplicity the proportions are not respected); the segments, on which the bendings are made to obtain the described form as an accordion, are dashed.-

Such example allows, further on to the constructive simplicity, also to implement a means not only for the electrical connection, but also able to mechanically damp the two terminal flat and parallel strips 6 and 6A.-

Figures 4 and 4A show a different example, wherein said flexible metallic foil is shaped with the two terminal flat strips 7 and 7A placed on two front planes, connected by a portion 7C arranged orthogonally to said terminal strips; a segment 7D of a first strip 7 is bent, so that the resulting side portion 7E be inclined with respect to both said frontal strips 7, 7A.

The size and the geometry of the described elements is such that the side edge 7G of said side strip 7E is in contact with the surface of the other strip 7A.-

Even in this case the figure 4A shows the symbolic extension on a plane of the just described foil.-

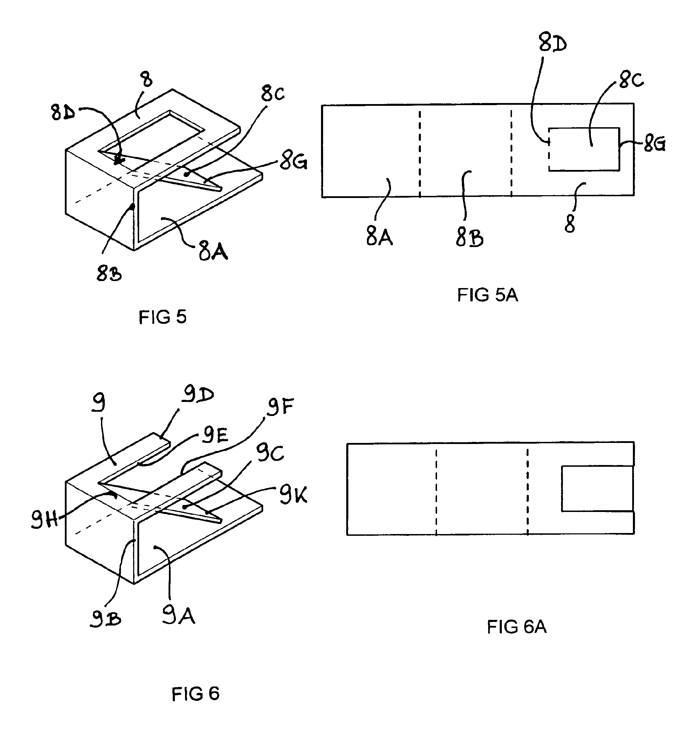

The figures 5 and 5A show a different example, wherein said metallic flexible foil is shaped with the two terminal strips arranged into two parallel and frontal strips 8 and 8A, connected by a portion 8B substantially orthogonal to said two strips; on a first strip 8 a partially closed shearing is made, which determines a third strip 8C, which is a part of said first strip 8. The segment 8D, not cut, is used as a bending line, according which said third strip is bent.

Said third strip 8C is inclined with respect to both said parallel strips 8, 8A, so that the side edge 8G of the strip 8A goes into contact with the surface of said other strip 8A.-

Even in this case the figure 5A shows the symbolic extension on a plane of the just described foil.

Figures 6 and 6A show a different example, wherein said flexible metallic strip is shaped into two terminal flat strips 9 and 9A arranged according two respective parallel and front planes, connected by a portion 9B placed substantially orthogonal to said two strips; on a first strip 9 a side or lateral portion 9C is defined, delimited by the side edge 9K of the same strip, by two parallel segments 9E and 9F, terminating on said edge 9K, and by a bending segment 9H arranged on said same first strip 9.-

On said two parallel segments 9E, 9F a sectioning is made, so that it is possible to bend said side portion 9C according to said bending segment 9H, until said side portion 9C be inclined with respect to both said parallel strips 9, 9A, so that its side edge 9K goes into contact with the surface of said other strip 9A. Even in this case the figure 6A shows the symbolic extension on a plane of the just described foil.-

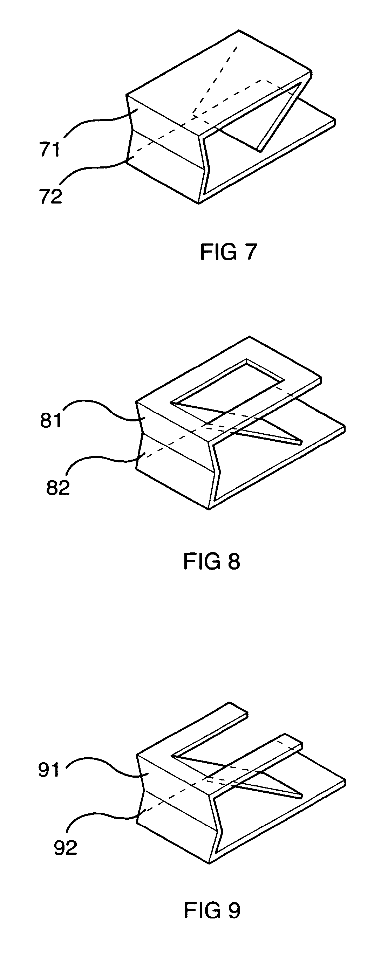

With ref. to the figure 7, 8 and 9, it may be observed that these are quite similar to the respective figures 4, 5 and 6, with the sole difference that said portions 7C, 8B and 9B, instead of being a flat and orthogonal portion to the other two strips, is realized by respective pairs of sub-portions 71 and 72, 81 and 82, 91 and 92, which are reciprocally inclined, and are inclined also to the respective parallel strips.

Such examples allow the advantageous result that said foil, once installed between the plate and the board, results more flexible and therefore more sensible to the contact on the same plate.-

With reference to the figure 2 and 2A, a simpler and so more profitable solution consists in the modification of the foil of fig. 5 simply eliminating the second strip 8A and the orthogonal portion 8B of fig. 5, and bending the inclined strip 5B (fig. 2), already previously bent, with a second bending on a second segment 5D, so that the terminal strip 5A so obtained is arranged on a plane parallel to the plane of the strip 5.-

Therefore the last solution shows that the two strips 5 and 5A are joined together through an inclined strip 5B, taken from the first strip 5.-

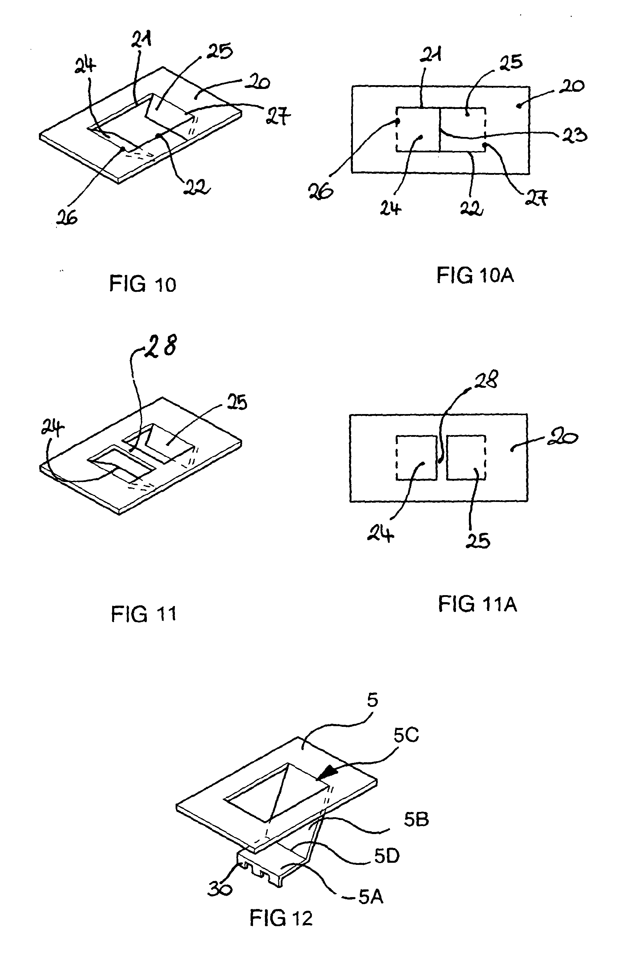

An embodiment of the invention is represented in the figures 10 and 10A; it can be observed that, differently from the previous figures, the metallic foil doesn't include two parallel and opposed strips, but only one strip 20, usually arranged into contact with the inner surface of the outer plate 1; the inner zone of said strip 20 is cut by two parallel and front cutting 21, 22, and by a transverse shearing 23, connecting the medial point of said parallel cuttings, so that two distinct portions 24 and 25 are defined; these remain joined with a respective edge 26 and 27 to said strip 20.-

Said same portions 24 and 25 are bent on said edges 26, 27 so that they result symmetrically inclined with respect to a plane which is orthogonal to said strip 20 and to said two shearings 21, 22.-

The advantage of such embodiment consists in obtaining an elastic foil symmetrically working with regard to a force orthogonal to the plane of the strip 20, and in a still simpler construction as it requires only one shearing operation and one bending operation, wherein such operations may obviously be carried out through only one pressing operation.-

A variation of the just described embodiment can be observed in the figures 11 and 11A; it may be observed that said two distinct inclined portions 24 and 25 are obtained not through a common transverse cutting 23 and the two parallel cuttings 21 and 22, but they are defined and cut in a fully independent way, and are separated by a small delimiting portion 28 comprised in said strip 20, so that said two portions 24 and 25 do not show any common cutting and bending.-

Of course the just described embodiment doesn't prevent that, from a production point of view, these distinct portions 24 and 25 can be obtained by a sole pressing operation.-

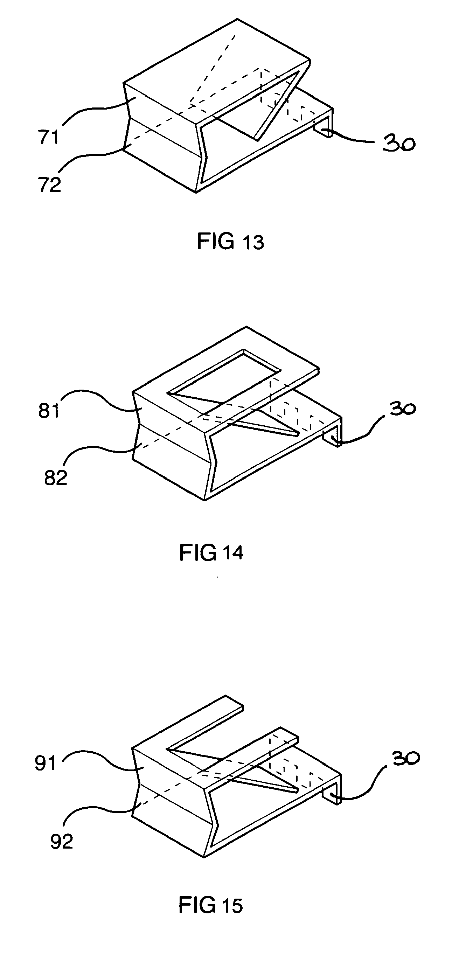

At last, with reference to the figures 12, 13, 14, 15 16 and 17 it can be observed that a portion of said foil, that can be either one of said flat terminal strips, or an inclined portion, is supplied with engaging teeth 30, which are able to be inserted in proper locations, not shown, arranged in correspondence to the connecting circuits on said printed circuit board, in order to favour the soldering and therefore the electrical connections between the same metallic foil and the relevant electrical circuit.-

## Claims

1. Capacitive touch control panel, particularly for household appliances, comprising:
- an outer plate (1) apt to be touched by the user ,
- a command assembly (2), implemented through a printed circuit board (PCB) arranged parallel to said outer plate and provided with components and electronic circuits (3) able of detecting the contact between said user and said outer plate, and of generating an electric signal corresponding to said contact condition, and comprising at least one contact element (4) placed on the surface of said board (PCB) oriented towards said outer plate,
- elastic, flexible and conductive means elastically arranged between said outer plate (1) and said board (PCB) and in galvanic contact with said at least one contact element (4), said elastic means comprising a flexible metallic foil,
**characterized in that**
said metallic foil has, in an inner area thereof, a plurality of cuts defining two distinct central portions (24, 25), each of which is joined to the rest of the foil only along one respective edge, said portions being bent along said edges on a same direction with respect to the rest of the foil.

2. Control panel according to any of the preceding claims, **characterized in that** said portions are supplied with engaging teeth (30).

## Patentansprüche

1. Kapazitiv-berührungsempfindliches Bedienfeld, insbesondere für Haushaltsgeräte, umfassend:
- eine Außenplatte (1), die vom Benutzer berührbar ist;
- eine Befehlsbaugruppe (2), implementiert durch eine Leiterplatte (PCB), die parallel zur Außenplatte angeordnet und mit Komponenten und elektronischen Schaltungen (3) ausgestattet ist, die geeignet sind, den Kontakt zwischen dem Benutzer und der Außenplatte festzustellen und ein elektrisches Signal in Entsprechung zu dieser Kontaktbedingung abzugeben, und die mindestens ein Kontaktelement (4) umfassen, das an der Oberfläche der Platte (PCB) platziert und der Außenplatte zugewandt ist;
- elastische, flexible und leitende Mittel, die elastisch zwischen der Außenplatte (1) und der Platte (PCB) und in galvanischem Kontakt mit dem mindestens einen Kontaktelement (4) angeordnet sind, wobei das elastische Mittel eine flexible Metallfolie umfasst;
**dadurch gekennzeichnet, dass**
die Metallfolie in einem Innenbereich derselben eine Mehrzahl von Schnitten aufweist, die zwei spezifische, mittlere Abschnitte (24, 25) abgrenzen, deren jeder mit dem Rest der Folie nur entlang jeweils einer Kante verbunden ist, wobei die Abschnitte entlang dieser Kanten in einer gleichen Richtung mit Bezug zum Rest der Folie gebogen sind.

2. Bedienfeld gemäß einem der vorangehenden Ansprüche, **dadurch gekennzeichnet, dass** die Abschnitte mit eingreifenden Zähnen (30) versehen sind.

## Revendications

1. Panneau de commande tactile capacitif, en particulier pour les appareils électroménagers, comprenant :
- une plaque externe (1) pouvant être touchée par l'utilisateur ;
- un ensemble de commande (2) implémenté via une carte de circuit imprimé (CCI) agencé parallèle à ladite plaque externe et doté de composants et de circuits électroniques (3) pouvant détecter le contact entre ledit utilisateur et ladite plaque externe, et générer un signal électrique correspondant à ladite condition de contact, et comprenant au moins un élément de contact (4) placé sur la surface de ladite carte (CCI) orienté vers ladite plaque externe,
- un moyen élastique, flexible et conducteur agencé élastiquement entre ladite plaque externe (1) et ladite carte (CCI) et en contact galvanique avec ledit au moins un élément de contact (4), ledit moyen élastique comprenant une feuille métallique flexible,
**caractérisé en ce que**
ladite feuille métallique a, dans une zone interne de celle-ci, une pluralité d'entailles définissant deux portions centrales distinctes (24, 25), dont chacune est jointe au reste de la feuille uniquement le long d'un bord respectif, lesdites portions étant courbées le long desdits bords dans une direction identique par rapport au reste de la feuille.

2. Panneau de commande selon la revendication précédente, **caractérisé en ce que** lesdites portions sont dotées de dents de mise en prise (30).
